# EUROPEAN PATENT APPLICATION

(11) **EP 1 806 622 A1**
(43) Date of publication of application: **11.07.2007**
(21) Application number: 05805227.5
(22) Date of filing: 25.10.2005
(51) Int. Cl.: G03F 7/32

(54) **DEVELOPER FOR THERMAL POSITIVE TYPE PHOTOSENSITIVE COMPOSITION**

(30) Priority: 28.10.2004 JP 2004314231
(71) Applicant: THINK LABORATORY CO., LTD., Chiba, 227-8525 (JP)
(72) Inventor: SATO, Tsutomu, c/o THINK LABORATORY CO., LTD., Kashiwa-shi, Chiba 277-8525 (JP)
(74) Representative: Grünecker, Kinkeldey, Stockmair & Schwanhäusser Anwaltssozietät
(86) International application number: PCT/JP2005/019539
(87) International publication number: WO 2006/046529

(57) **Abstract**

Provided is a developer for thermal positive type photosensitive composition, which is easy in developer handling such as pH adjustment, has a developing treatment capability ensuring durability in multiple uses, has little change of pH value over a prolonged period of time and is excellent in durability, has a development capability capable of satisfactorily developing of 100 or more rolls, preferably about 300 to 400 rolls so that the developer can be applied especially to photoengraved rolls for gravure printing, and exhibits a buffering action and is minimized in the aging deterioration of processing capacity so as to realize reduction of the frequency of developer replacement. The developer for thermal positive type photosensitive composition comprises a weak alkaline aqueous solution containing (A) triethanolamine and/or diethanolamine and (B) at least one member selected from the group consisting of: potassium pyrophosphate; sodium tripolyphosphate; and sodium hexametaphosphate.

## Description

### Technical Field

The present invention relates to a developer for a thermal positive photosensitive composition, and more specifically, to a developer for use in developing a thermal positive photosensitive composition having sensitivity to an infrared wavelength laser, in which a sensing portion becomes soluble to the developer by being exposed to and sensing the infrared wavelength laser.

### Background Art

Conventionally, there have been known positive type photosensitive compositions having sensitivity to infrared wavelength lasers, in which a sensing portion becomes soluble to a developer by being exposed to and sensing the infrared wavelength lasers (see, for example, Patent Documents 1 to 6). This type of positive type photosensitive compositions cannot be developed by using a strong alkaline developer having a pH of about 13 or more. Patent Documents 7 and 8 disclose developers for the positive type photosensitive compositions. However, those developers are strong alkaline, and thus absorb carbon dioxide gas to cause change with time thereof at relatively early stages. In addition, development residues sometimes remain when the pH of the developer is 13 or less, resulting in difficulty in maintaining stable development. Accordingly, the inventor of the present invention has developed a novel thermal positive type photosensitive composition which can be developed by using a developer having a low pH (around pH 9.5 to 12) where absorption of the carbon dioxide gas is relatively small. The present invention relates to a weak alkaline developer (having a pH of 12.5 or less) which copes with the thermal positive type photosensitive composition.

In order to put such a developer into practical use in lithographic printing or gravure printing, it is desirable that the developer has the capability to develop at least approximately 100m² and exhibits a buffering action, and that deterioration with time in the treatment capability thereof is extremely small, that is to say, there is no fear that the developing capability has disappeared to disable the development when the developer is used again after the elapse of a few days to one week, with the result that the developer in a developer tank is entirely discharged and another developer is prepared again.

In order to solve the above-mentioned problems, the inventor of the present invention has proposed a developer for a positive type photosensitive composition containing: at least one of sodium orthosilicate, potassium pyrophosphate, sodium tripolyphosphate, sodium hexametaphosphate, and sodium monophosphate; a surfactant; and a developing accelerator (Patent Document 9). However, the developer had a problem in that the pH of the solution of the developer was difficult to control.
Patent Document 1: JP 09-043847 A
Patent Document 2: JP 10-268512 A
Patent Document 3: JP 11-084657 A
Patent Document 4: JP 11-174681 A
Patent Document 5: JP 2003-337409 A
Patent Document 6: JP 2004-102062 A
Patent Document 7: JP 08-023447 A
Patent Document 8: JP 61-167948 A
Patent Document 9: JP 2004-004438 A

### Disclosure of the Invention

### Problems to be solved by the Invention

The present invention has been made in view of the above-described points. It is an object of the present invention to provide a developer for a developable thermal positive type photosensitive composition developable by using a developer having a pH of about 9 to 12, which: is easy in developer handling such as pH adjustment; has a developing treatment capability ensuring durability in multiple uses; has little change of pH value over a prolonged period of time, and is excellent in durability; has a developing capability capable of satisfactorily developing 100 or more rolls, preferably about 300 to 400 rolls so that the developer can be practically applied to photoengraved rolls for gravure printing; exhibits a buffering action; and is minimized in the aging deterioration of processing capability so as to realize reduction of the frequency of developer replacement.

### Means for solving the Problems

In order to solve the above-described problems, a developer for a thermal positive photosensitive composition according to the present invention includes a weak alkaline solution containing: (A) triethanolamine and/or diethanolamine; (B) at least one selected from the group consisting of: potassium pyrophosphate; sodium tripolyphosphate; and sodium hexametaphosphate. It is preferable that a pH value of the developer according to the present invention be within a range of from 9.1 to 10.

The developer according to the present invention preferably further includes (C) a surfactant. In addition, the developer according to the present invention preferably further includes (D) a developing accelerator.

### Effect of the Invention

According to the present invention, there can be provided a developer for a thermal positive photosensitive composition, which is easy in developer handling such as pH adjustment, has a developing treatment capability ensuring durability in multiple uses, exhibits a buffering action, has little change of pH value over a prolonged period of time, and is excellent in durability, and in particular, which is suitably used for developing treatment using a gravure printing plate. The developer of the present invention used for developing a thermal positive photosensitive composition has a pH value of within a range of from 9 to 12. In the case of applying the developer for a thermal positive photosensitive composition according to the present invention to a roll to be processed for the gravure printing, even if 300 rolls or more are treated, the predetermined pH value is stably maintained and a good development with good pattern sharpness can be realized in a short time. Moreover, deterioration with time in the treatment capability is extremely small. Accordingly, it is not necessary to entirely discharge the developer in a developer tank and to exchange the developer with a new developer, which may be caused by the fact that the developing capability has disappeared to disable the development when the developer is used again after the elapse of two to three days to one week. The developer according to the present invention exerts such enormous effects as described above.

### Best Mode for carrying out the Invention

Although embodiments of the present invention are described below, it is needless to say that the embodiments are described only for illustration purposes, and that various modifications are possible without departing from a technical concept of the present invention.

A developer for a thermal positive photosensitive composition according to the present invention includes a weak alkaline solution containing (A) triethanolamine and/or diethanolamine; and (B) at least one compound selected from the group consisting of: potassium pyrophosphate; sodium tripolyphosphate; and sodium hexametaphosphate. It is preferable that a pH value of the developer according to the present invention have a weak alkalinity of less than 12.5, has pH value of within a range of from 8.8 to 12.3, and more preferably, has pH value of within the range of from 9.1 to 10.

A mixing ratio of the triethanolamine and/or diethanolamine (A) is main material for keeping the developer alkaline and performing alkaline development. A mixing ratio of the compound (A) is suitably selected according to applied positive type photosensitive compositions, developing conditions, and the like. However, it is preferable to mix the quaternary ammonium hydroxide at 0.01 to 5 wt%, more preferably 0.01 to 3 wt%, on the basis of the developer. The triethanolamine and diethanolamine can be used singly or in combination thereof.

The compound (B) selected from the group consisting of: potassium pyrophosphate; sodium tripolyphosphate; and sodium hexametaphosphate has a buffer function by absorbing the carbonic acid gas to prevent the pH value of the developer from decreasing owing to carbonic acid gas entering the developer or generated therein. Although a mixing ratio of the compound (B) is not particularly limited, it is preferable to mix the compound (B) at 0.01 to 5 wt%, more preferably 0.05 to 2 wt% on the basis of the developer.

It is preferable to further mix a surfactant (C) to the developer according to the present invention. The surfactant (C) functions to help the developer exhibit activity and permeate through a photosensitive film of an exposed portion, and to promote dissolution of the photosensitive film. As the surfactant (C), there are widely usable well-known surfactants such as anionic, cationic, nonionic, and amphoteric ion surfactants. Specifically, preferable examples of the surfactant (C) include sodium ester of α-sulfofatty acid, sodium linear alkylbenzene sulfonate, sodium alkyl sulfate, sodium alkyl ether sulfate, sodium α-olefin sulfonate, sodium alkylsulfonate, ester of sucrose fatty acid, ester of sorbitan fatty acid, ester of polyoxyethylene sorbitan fatty acid, fatty acid alkanolamide, polyoxyethylene alkyl ether, polyoxyethylene alkyl phenyl ether, sodium alkylaminofatty acid, alkyl betaine, alkyl amine oxide, alkyl trimethyl ammonium salt, dialkyl dimethyl ammonium salt, and the like. Those surfactants can be used singly or in combination of two or more thereof. Although a mixing ratio of the surfactant (C) is not particularly limited, the mixing ratio is preferably 0.1 to 1.2 wt%, more preferably 0.2 to 1.0 wt% on the basis of the developer.

It is preferable to further mix a developing accelerator (D) to the developer according to the present invention. The developing accelerator (D) functions not to remain the development residue. For example, the developing accelerator includes normal propanol, isopropanol, butanol, isoamyl alcohol, benzyl alcohol, dimethyl sulfoxide, N-methylpyrrolidone, ethylene glycol phenyl ether, ethylene glycol benzyl ether, cyclohexane, cyclohexanol, N-benzylethanolamine, anisyl alcohol, dimethylbenzyl alcohol, N-phenylethanolamine, propylene glycol monophenyl ether, tripropylene glycol monomethyl ether, phenylglycol, and the like. Those developing accelerators can be used singly or in combination of two or more thereof. Although a mixing ratio of the developing accelerator (D) is not particularly limited, the mixing ratio is preferably 0.1 to 10 wt%, more preferably 0.1 to 5 wt%, on the basis of the developer.

The developer according to the present invention is applied for developing the thermal positive photosensitive composition having an alkaline developer with a pH within the range of from 9 to 12. The thermal positive photosensitive composition is not particularly limited, and publicly known ones are widely usable. However, the developer is preferably used for an alkali-soluble thermal positive photosensitive composition having sensitivity to an infrared wavelength laser, in which a sensing portion becomes soluble to the alkaline developer by being exposed to and sensing a laser beam with a wavelength of 650 to 1,300 nm, preferably 700 to 1,100 nm. As the thermal positive photosensitive composition, there is specifically cited a composition containing, as essential components, an alkali-soluble polymer substance, and a photothermal conversion substance absorbing light of an image exposure light source and converting the light into heat. For example, the composition includes ones described in PCT/JP2004/9007, which is previously filed by the inventor of the present invention, and the like.

As the alkali-soluble polymer substance, an alkali-soluble organic polymer substance (hereinafter, referred to as a carboxyl group-containing organic polymer substance) having a -COOR (where R is a hydrogen atom or a monovalent organic group) group is preferable. The alkali-soluble organic polymer substance is a main component for forming resist, and is binder resin having low adhesion to a copper-plated surface or a copper sulfate-plated surface. A main or side chain portion of a molecule of the alkali-soluble organic polymer substance is cut by heat to convert into low molecules in which the alkali solubility is further enhanced. A part of the low molecules is ablated.

As the carboxyl group-containing organic polymer substance, for example, there is exemplified a carboxyl group-containing polymer substance as described in PCT/JP2004/9007, and there are preferable a polymer obtained from an unsaturated compound (a1) having at least one carboxyl group and/or a carboxylic acid anhydride group, and a copolymer obtained from the unsaturated compound (a1) and a compound (a2) copolymerizable with the unsaturated compound. Specifically, preferable examples include a maleic acid polymer, a (meth)acrylic acid polymer, a styrene/maleic acid-series copolymer, and derivatives thereof, and there is particularly preferable a styrene/maleic acid-series copolymer obtained by reacting a compound having a hydroxyl group with the styrene/maleic anhydride-series copolymer.

Those alkali-soluble polymer substances can be used singly or in combination of two or more thereof. A content ratio of the alkali-soluble organic polymer substance in the thermal positive photosensitive composition is preferably 2 to 98 wt%, more preferably 30 to 90 wt%.

As the photothermal conversion substance, known photothermal conversion substances are widely usable. For example, the photothermal conversion substance includes organic or inorganic pigment and dye each having an absorption band in a part or all of the infrared range with the wavelength range of from 650 to 1300 nm, absorbing an infrared ray, and converting the infrared ray into heat, and photothermal conversion colorants such as organic colorant, metal, metal oxide, metal carbide, and metal boride, as described in Patent Documents 1 to 6. Those photothermal conversion substances get involved in lowering molecular weight and ablation of the alkali-soluble nature caused by the thermal cutting of the molecules of the alkali-soluble organic polymer substance.

As representative one of the photothermal conversion substances, there is exemplified so-called cyanine colorant in a broad sense, in which heterocycles containing nitrogen atoms, oxygen atoms, sulfur atoms, or the like are bonded by polymethine (-CH=)n. Specifically, for example, the cyanine colorant includes ones of quinoline series (so-called cyanine series), indole series (so-called indocyanine series), benzothiazole series (so-called thiocyanine series), iminocyclohexadiene series (so-called polymethine series), pyrylium series, thiapyrylium series, squarylium series, croconium series, azulenium series, and the like. Among them, the colorants of quinoline series, indole series, benzothiazole series, iminocyclohexadiene series, pyrylium series, or thiapyrylium series are preferable.

Those photothermal conversion substances can be used singly or in combination of two or more thereof. A content ratio of the photothermal conversion substance in the thermal positive photosensitive composition is preferably 2 to 60 wt%, more preferably 3 to 50 wt%.

It is preferable that the thermal positive photosensitive composition contain various additives such as an adhesion improver, a dissolution inhibitor, a photoacid generator, dye, an intensifier, a developing accelerator, and a coating improver. The adhesion improver is preferably at least one selected from the group consisting of: vinylpyrrolidone/vinyl acetate copolymer; vinylpyrrolidone/dimethylaminoethyl methacrylate copolymer; vinylpyrrolidone/vinylcaprolactam/dimethylaminoethyl methacrylate copolymer; polyvinyl acetate; polyvinyl butyral; polyvinyl formal; terpenephenol resin; alkylphenol resin; melamine/formaldehyde resin; and ketone resin.

In usual, the thermal positive photosensitive composition is used as a solution obtained by dissolving the respective components into a solvent such as a cellosolve solvent and a propylene glycol solvent. A usage ratio of the solvent is usually within a range of from 1 to 20 times a total amount of solid contents of the photosensitive composition on a weight ratio basis.

With regard to the developer according to the present invention, it is preferable to prepare a stock solution of the developer, in which concentrations of the respective components are enhanced, to dilute the stock solution before use, and to use the diluted solution as the developer. Although usage of the developer according to the present invention is not particularly limited, the following usage is preferable. The stock solution of the developer and water are mixed and vatted, and the thermal positive photosensitive composition is coated on a support surface (for example, in the case of gravure printing, on a copper-plated surface or copper sulfate-plated surface of a roll to be processed for the gravure printing), and a photosensitive film is formed. Thereafter, the photosensitive film is irradiated with a near-infrared wavelength laser in a blinking manner, thus being exposed thereto to draw a positive latent image thereon, and then the development is performed.

A development method is not particularly limited, and known methods are adopted. In usual, the development is performed at a temperature ranging from 15 to 45 °C, preferably 22 to 32 °C by means of immersion development, spray development, brush development, ultrasonic development, and the like.

As a coating method of the thermal positive photosensitive composition on the support surface, there are usable kiss coating, dip coating, rotation coating, roll coating, wire bar coating, air knife coating, blade coating, curtain coating, and the like. It is preferable to set a coating amount within a range of from 1 to 6 µm in terms of thickness.

### Examples

The present invention is described more specifically by way of examples below. It is needless to say that these examples are described only for illustration purposes, and should not be restrictively construed.

### (Examples 1 to 8)

A roll to be processed was attached onto a photosensitive film coating apparatus (manufactured by Think Laboratory Co., Ltd.) installed in a coating chamber in which humidity was maintained at 40% or less, and a thermal positive photosensitive composition was coated thereon. Subsequently, the thermal positive photosensitive composition was dried at 130 °C, and a positive photosensitive film was formed so that a remaining solvent could become 2% or less and a film thickness could be 2 to 3 µm. Next, the positive photosensitive film was irradiated with a laser with a wavelength of 830 nm in a blinking manner by means of a laser exposure apparatus, thus being exposed thereto to draw a positive latent image thereon. Thus, a roll to be tested was prepared. Incidentally, as the thermal positive photosensitive composition, there was used a photosensitive solution (100 parts by weight of a partial ester compound derived from butyl cellosolve of a styrene/maleic anhydride copolymer, 1 part by weight of cyanine colorant, 5 parts by weight of vinylpyrrolidone/vinyl acetate copolymer, 5 parts by weight of TrisP-PA (produced by Honshu Chemical Industry Co., Ltd., dissolution inhibitor), 800 parts by weight of propylene glycol monomethyl ether, 800 parts by weight of isopropyl alcohol, and 600 parts by weight of methyl ethyl ketone).

A stock solution of a developer with a composition shown in Table 1 was prepared, and the stock solution of the developer was diluted with water in a development tank (ratio of water and the stock solution: 4:1), whereby the developer was prepared. Incidentally, pH of the developer was within a range of from 9.1 to 10. The roll to be tested was set in a development apparatus, and the development was performed for 50 seconds. Then, in all of Examples 1 to 8, a good development without any residue on an image area of a resist screen (that is, a portion from which resist was removed) and with good pattern sharpness was realized. Thereafter, the developing treatment was continuously performed for 600 rolls without exchanging the developer. Then, even after treating the 600 rolls, the developers of Examples 1 to 8 stably maintained the pH value within the range of from 9 to 10, and realized the good development with the good pattern sharpness in a short time. Moreover, the deterioration with time in the treatment capability of each developer was extremely small, and each developer of Examples 1 to 8 had a good developing capability even after the elapse of two days to one week from the development.

**[Table 1]**

| | Example | | | | | | | | Experimental Example |
|---|---|---|---|---|---|---|---|---|---|
| | 1 | 2 | 3 | 4 | 5 | 6 | 7 | 8 | 1 |
| (A)Triethanolamine | 2.5 | 0.7 | 1.0 | 0.6 | 5.3 | 2.5 | 7.0 | 5.0 | 5.3 |
| (B)Potassium pyrophosphate | 0.6 | 1.7 | - | - | 0.9 | 0.9 | - | 0.6 | - |
| (B)Sodium tripolyphosphate | 0.6 | - | 1.7 | - | 0.8 | - | 0.9 | 0.6 | - |
| (B)Sodium hexametaphosphate | 0.6 | - | - | 1.7 | - | 0.8 | 0.8 | 0.6 | - |
| (C)Surfactant | 2.0 | 0.8 | 3.5 | 1.0 | 2.0 | 0.5 | 1.5 | - | 2.0 |
| (D)Developing Accelerator | 1.0 | 1.0 | 1.0 | 1.0 | 1.0 | 1.0 | 1.0 | - | 1.0 |

In Table 1, the blend ratios of the blended materials are represented by weight%, and fatty acid alkanolamide was used as the surfactant and isopropanol was used as the developing accelerator. The balance of the components of the developer was water.

### (Experimental Example 1)

The development was performed in a similar way to Example 1 except that the composition of the stock solution of the developer was changed as in Table 1. Then, a residue was observed a little on the image area of the resist screen. Moreover, a treatment capability here was only for several rolls, and on the following day from a day when the development was performed, the treatment capability was entirely lost though a decrease of the pH value was not observed.

### (Example 9)

The development was performed in a similar way to Example 1 except that a stock solution of a developer containing diethanolamine was used instead of triethanolamine. As a result, as in Example 1, the developing capability and stability with time were extremely good and development of 600 rolls was able to be performed. Note that pH of the developer was in a range of from 9.1 to 10.

### (Experimental Example 2)

The development was performed in a similar way to Example 1 except that a stock solution of a developer containing monoethanolamine was used instead of triethanolamine. As a result, the resultant developer was strong alkaline, and had poor stability with time.

## Claims

1. A developer for a thermal positive type photosensitive composition, comprising a weak alkaline aqueous solution containing:
(A) triethanolamine and/or diethanolamine; and
(B) at least one member selected from the group consisting of potassium pyrophosphate; sodium tripolyphosphate; and sodium hexametaphosphate.

2. The developer according to claim 1, wherein the developer has a pH within a range of from 9.1 to 10.

3. The developer according to claim 1 or 2, wherein the weak alkaline solution further contains (C) a surfactant.

4. The developer according to any one of claims 1 to 3, wherein the weak alkaline solution further contains (D) a developing accelerator.
